Europäisches Patentamt

European Patent Office

Office européen des brevets

(19)

(11) Veröffentlichungsnummer: 0 388 679
A1

## (12) EUROPÄISCHE PATENTANMELDUNG

(21) Anmeldenummer: 90104022.0

(22) Anmeldetag: 01.03.90

(51) Int. Cl.5: G02B 6/42, H01L 31/0232,
H01S 3/025

(30) Priorität: 22.03.89 DE 3909552

(43) Veröffentlichungstag der Anmeldung:
26.09.90 Patentblatt 90/39

(84) Benannte Vertragsstaaten:
DE GB

(71) Anmelder: Siemens Aktiengesellschaft
Wittelsbacherplatz 2
D-8000 München 2(DE)

(72) Erfinder: Greil, Andreas, Dipl.-Phys.
Preysingstrasse 32
D-8000 München 80(DE)
Erfinder: Taumberger, Franz
Stiftsbogen 118
D-8000 München 70(DE)

(54) Verfahren zum Justieren und Fixieren einer Linse und damit hergestellte optische Koppelanordnung.

(57) Mit einem Verfahren zum Justieren und Fixieren einer Linse (2) vor einem optoelektronischen Bauelement (1), die auf einem Träger (5) angeordnet miteinander optisch gekoppelt werden, soll die Linse (2) mit hoher Genauigkeit justiert und hoher Langzeitstabilität fixiert werden. Die Linse (2) wird in der Stirnseite eines Metallröhrchens (3) gehalten und das Metallröhrchen (3) vor dem Bauelement (1) in einer Metallschelle (4) nach einem ersten Justiervorgang am Träger (5) festgeschweißt. Danach wird das Metallröhrchen (3) in mehreren aufeinanderfolgenden Schritten nach jeweils einem weiteren Justiervorgang punktweise mit der Metallschelle (4) verschweißt.

Hauptanwendungsgebiet: Elektrooptische Wandlermodule.

## FIG 1

EP 0 388 679 A1

## Verfahren zum Justieren und Fixieren einer Linse und damit hergestellte optische Koppelanordnung.

Die Erfindung betrifft ein Verfahren zum Justieren und Fixieren einer Linse nach dem Oberbegriff des Anspruchs 1 und eine damit hergestellte Koppelanordnung.

Bei optoelektronischen Sende- und/oder Empfangsmodulen mit Lichtwellenleiter-Übertraguggsstrecken für die optische Nachrichtenübertragung besteht das Problem, das optoelektronische Halbleiterbauelement an einen Lichtwellenleiter in der gewünschten Weise optisch anzukoppeln. Die Kopplung von einem optoelektronischen Bauelement in eine Monomode- oder Multimodefaser erfolgt dabei über eine Freistrahloptik in einem Modul mit mindestens einer Linse. Bei diesem Einsatz muß vor dem optoelektronischen Halbleiterbauelement, beispielsweise einer Laserdiode, eine Linse im Submikrometerbereich, d.h. mit einer Justiertoleranz <0,2μm, feinjustiert und fixiert werden.

Es ist bekannt, zum Herstellen derartiger Koppelanordnungen beispielsweise einen Lichtwellenleiter mit halbkugelförmigem Abschluß oder eine Linse, beispielsweise eine Kugellinse, auf einem Träger, beispielsweise aus Silizium, anzuordnen und in flüssigem Lot zu justieren (EP-A-0204224).

Das Justieren von Linsen, auch von für diesen Zweck aus Kostengründen bevorzugt verwendeten Kugellinsen, ist in einem flüssigen Material allerdings schwierig. Zudem ist die Festigkeit einer solchen Verbindung nach erfolgter Abkühlung und Verfestigung des Lotes insbesondere im Hinblick auf die geforderte Dauerhaftigkeit einer derartigen, gegenüber mechanischen Belastungen besonders empfindlichen optischen Koppelanordnung nicht immer gewährleistet.

Der Erfindung liegt die Aufgabe zugrunde, ein Verfahren zum Justieren und Fixieren der eingangs genannten Art dahingehend zu verbessern, daß bei einer nach diesem Verfahren hergestellten optischen Koppelanordnung bedingt durch eine exakte Justage ein hoher optischer Koppelwirkungsgrad und durch eine feste, mechanisch stabile Verbindung eine hohe Langzeitstabilität gewährleistet ist.

Diese Aufgabe wird erfindungsgemäß durch ein Verfahren mit den Merkmalen des Anspruchs 1 und eine Anordnung mit den Merkmalen des Anspruchs 5 gelöst.

Vorteilhafte Ausgestaltungen bzw. Weiterbildungen der Erfindung sind Gegenstand zusätzlicher Ansprüche.

Der Erfindung liegt die Erkenntnis zugrunde, daß einerseits eine Schweißverbindung eine mechanisch sehr stabile Befestigungsart darstellt, daß aber andererseits ein verzugsfreies Schweißen unmöglich ist. Ausgehend von dieser Erkenntnis werden die Schweißpunkte bei dem erfindungsgemäßen Verfahren so gesetzt, daß der unvermeidbare Verzug immer gegenläufig ist. Die zweckmäßig aus Metall bestehende Schelle ist dabei so konstruiert, daß beim Justieren das zweckmäßig aus Metall bestehende Röhrchen, das die Funktion der Linsenhalterung innehat, am Umfang stets einen spaltfreien Berührungspunkt mit der Metallschelle bildet. Erreicht wird dies durch den Radius an der Metallschelle.

Die Metallschelle ist zweckmäßig mit dem Wärmeausdehnungskoeffizienten an den Ausdehnungskoeffizienten des Trägers (Subträgers), der vorzugsweise aus Kupfer besteht, angepaßt. Der Träger wird zum Zweck des Justierens und Fixierens der Linse bzw. des die Linse tragenden Metallröhrchens auf einem Montageelement montiert.

Die Schweißverbindung Metallschelle (z .B. mit Nickeloberfläche)-Träger (z.B. Kupfer vergoldet) wird durch das Durchschweißen der Metallschelle mittels Laserstrahl erreicht.

Die Linse, vorzugsweise eine Kugellinse, wird in einem Metallröhrchen eingepreßt, eingeglast, eingeklebt, eingelötet oder eingeschrumpft.

Das Metallröhrchen wird vor dem optoelektronischen Halbleiterbauelement in einer Metallschelle nach dem ersten Justiervorgang am Träger des optoelektronischen Bauelements mit dem Laserschweißverfahren in Form von mehreren Schweißpunkten festgeschweißt. Das Metallröhrchen ist dabei in einer Festspannzange gehaltert, die in Richtung der x-, y- und z-Achse justiert werden kann.

Danach wird die Linse wieder auf Optimum justiert und der erste Schweißpunkt an der Berührungsstelle Metallschelle-Metallröhrchen gesetzt. Sodann wird die Linse erneut auf Optimum justiert und dem eventuell ermittelten Schweißverzug vorgehalten. Die nächsten Schweißpunkte werden der Reihe nach geschweißt, wobei nach jeder Schweißung die Einkopplung korrigiert wird. Der Verzug wird nach jedem Schweißpunkt immer geringer und somit auch das nötige Nachjustieren.

Außerdem kann nach dem Setzen des letzten Schweißpunktes die Position der Linse, über die Hebelwirkung Röhrchen-Schelle, nochmals fein nachkorrigiert werden.

Die mit der Erfindung erzielten Vorteile bestehen insbesondere darin, daß mit diesem Justierverfahren große Aufbautoleranzen überbrückt werden können. Darüber hinaus hat die Schweißfixierung gegenüber einer Lötfixierung eine weitaus bessere Langzeitstabilität. Hinzu kommt, daß die Konstruktion so gewählt ist, daß die Handhabung und das Fixierschleißen in einem offenen Modulgehäuse gut realisierbar ist.

Außerdem hat man bei der Justierung durch die Schweißzange (Manipulator) eine Untersetzung und kann so mit geringerem Aufwand auf 0,1µm genau justieren. Von weiterem Vorteil ist, daß der Bauelementträger, beispielsweise ein Laserträger, einfacher gestaltet werden kann, und daß sogar bei herkömmlichen Bauelementträgern das vorgeschlagene Justierverfahren realisiert werden kann. Außerdem können zum Herstellen der optoelektronischen Koppelanordnung einfache und damit billige Bauteile verwendet werden.

Ein anderer Vorteil des erfindungsgemäßen Verfahrens besteht darin, daß durch eine rein mechanische Verbindung der Linse mit dem Metallröhrchen als Halterung, nämlich durch die Möglichkeit des Einpressens bzw. Einschrumpfens der Linse in das Röhrchen, ein Bedecken der optisch aktiven Fläche der Linse vermieden wird.

Anhand eines in den Figuren der Zeichnung dargestellten, bevorzugten Ausführungsbeispiels wird die Erfindung weiter erläutert. Es zeigen

Fig. 1 eine erfindungsgemäße Koppelanordnung in Seitenansicht und

Fig. 2 eine Draufsicht auf die Koppelanordnung nach Fig. 1.

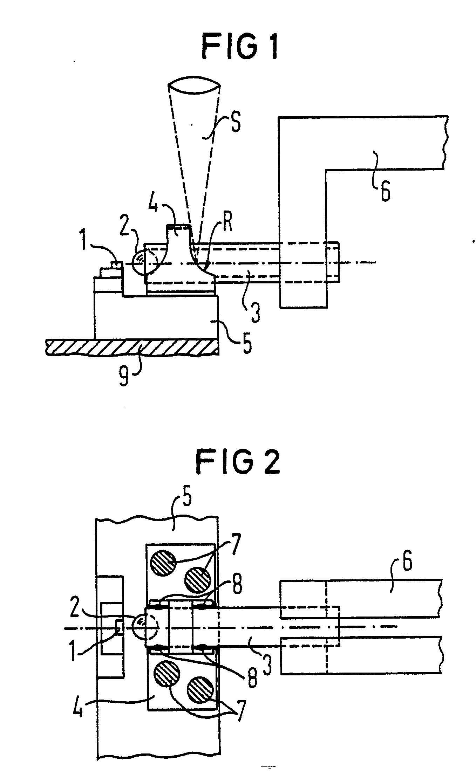

Die in den Figuren 1 und 2 dargestellte optische Koppelanordnung besteht im wesentlichen aus einer Linse 2, in diesem Ausführungsbeispiel einer Kugellinse, die vor einem optoelektronischen Halbleiterbauelement 1, in diesem Beispiel einer Laserdiode, auf einem Träger 5 justiert und fixiert ist. Der Träger 5 besteht dabei vorzugsweise aus Kupfer. Beim Durchführen des Justier- und Fixierverfahrens ist der Träger 5 auf einem Montageelement 9 befestigt. Als Justiervorrichtung wird beim Durchführen des Verfahrens eine in Richtung der x-, y- und z-Achse justierbare Festspannzange 6 verwendet. Das Verschweißen der zu fixierenden Einzelteile wird mit Hilfe eines Laserstrahles S vorgenommen und geschieht zweck mäßig punktweise. Die Kugellinse 2 ist in der Stirnseite eines Metallröhrchens 3, das zweckmäßig dünnwandig ausgebildet ist, befestigt. Über das Metallröhrchen 3 ist eine Schelle 4 gestülpt, die zweckmäßig auch aus Metall besteht. Die Metallschelle 4 wird, nachdem das Metallröhrchen 3 mit der Linse 2 vor der Laserdiode 1 auf optimale Lichteinkopplung justiert ist, auf dem Träger 5 festgeschweißt, und zwar in Form von mehreren Laserschweißpunkten 7. Dann wird die Linse 2 mit dem Metallröhrchen 3 mit Hilfe der Festspannzange 6 erneut auf optimale Lichteinkopplung des von der Laserdiode 1 herrührenden Lichtes justiert und das Metallröhrchen 3 mit einem Laserschweißpunkt 8 an der Metallschicht 4 fixiert. Dieser Vorgang wird mehrmals wiederholt, bis genügend - in diesem Beispiel vier - Laserschweißpunkte 8 gesetzt sind, um die geforderte dauerhafte Fixierung der Linse 2 bei optimaler Justierung der Koppelanordnung zu gewährleisten. Die Schweißpunkte 8 sind dabei so gesetzt, daß der beim Punkten auftretende Verzug immer gegenläufig ist. Außerdem ist die Schelle 4 so geformt, daß beim schrittweisen Justieren des Metallröhrchens 3 an dessen Umfang stets ein spaltfreier Berührungspunkt zum Verschweißen mit der Metallschelle 4 gebildet ist. Das wird vorteilhaft dadurch erreicht, daß die Metallschelle 4 so gestaltet ist, daß deren von einem gemeinsamen Ansatzpunkt ausgehende Schenkel sich nach unten zu ihren Befestigungsteilen, in diesem Beispiel zu dem Träger 5 bzw. zu den Laserschweißpunkten 7 hin radial, d.h. mit einem Radius R, erweitern.

Die Erfindung ist auf das dargestellte Ausführungsbeispiel nicht beschränkt. Das optoelektronische Halbleiterbauelement muß nicht unbedingt ein lichtemittierendes Bauelement sein. Es kann als Lichtempfänger beispielsweise auch ein Fototransistor oder eine Fotodiode sein. Außerdem kann es vorteilhaft sein, die Linse als Bestandteil eines Lichtwellenleiters in dem Metallröhrchen zu befestigen.

Eine erfindungsgemäße optische Koppelanordnung findet vorzugsweise als Bauteil in einem optoelektronischen Sende-und/oder Empfangsmodul Anwendung.

**Ansprüche**

1. Verfahren zum Justieren und Fixieren einer Linse vor einem optoelektronischen Halbleiterbauelement, die auf einem Träger angeordnet miteinander optisch gekoppelt werden, **dadurch gekennzeichnet**, daß die Linse (2) in der Stirnseite eines Metallröhrchens (3) gehaltert wird, daß das Metallröhrchen (3) vor dem optoelektronischen Halbleiterbauelement (1) in einer Metallschelle (4) nach einem ersten Justiervorgang am Träger (5) festgeschweißt wird, und daß dann das Metallröhrchen (3) in mehreren aufeinanderfolgenden Schritten nach jeweils einem weiteren Justiervorgang punktweise mit der Metallschelle (4) verschweißt wird.

2. Verfahren nach Anspruch 1, **dadurch gekennzeichnet**, daß die Metallschelle (4) so geformt wird, daß beim schrittweisen Justieren des Metallröhrchens (3) an dessen Umfang stets ein spaltfreier Berührungspunkt zum Verschweißen mit der Metallschelle (4) gebildet wird.

3. Verfahren nach Anspruch 1 oder 2, **dadurch gekennzeichnet**, daß die Metallschelle (4) so geformt wird, daß deren von einem gemeinsamen Ansatzpunkt ausgehende Schenkel sich nach unten zu ihren Befestigungsteilen hin radial erweitern.

4. Verfahren nach einem der Ansprüche 1 bis 3, **dadurch gekennzeichnet**, daß die Wärmeausdehnungskoeffizienten des Metallröhrchens (3), der Metallschelle (4) und des Trägers (5) aneinander angepaßt werden.

5. Anordnung zum optischen Koppeln eines optoelektronischen Bauelements mit einer optischen Linse, die vor dem optoelektronischen Bauelement auf einem Träger justiert und fixiert ist, nach einem der Ansprüche 1 bis 4, **dadurch gekennzeichnet**, daß die Linse (2) in der Stirnseite eines Metallröhrchens (3) gehalten ist, daß das Metallröhrchen (3) mit der Linse (2) mittels einer Metallschelle (4) vor dem optoelektronischen Bauelement (1) einjustiert auf den Träger (5) festgeschweißt ist, und daß das Metallröhrchen (3) mit der Linse (2) auf optimale Lichtkopplung feinjustiert an der Metallschelle (4) durch Punktschweißen befestigt ist.

6. Anordnung nach Anspruch 5, **dadurch gekennzeichnet**, daß die optische Linse (2) Bestandteil eines Lichtwellenleiters ist.

7. Anordnung nach Anspruch 5, **dadurch gekennzeichnet**, daß die optische Linse (2) eine Kugellinse ist.

8. Anordnung nach einem der Ansprüche 5 bis 7, **dadurch gekennzeichnet**, daß das optoelektronische Bauelement (1) eine Laserdiode ist.

9. Anordnung nach einem der Ansprüche 5 bis 7, **dadurch gekennzeichnet**, daß das optoelektronische Bauelement (1) ein Fototransistor ist.

10. Anordnung nach einem der Ansprüche 5 bis 9, **gekennzeichnet durch** ihre Verwendung als Bauteil in einem optoelektronischen Sende- und/oder Empfangsmodul.

# FIG 1

S

R

6

4

2

1

3

5

9

# FIG 2

5

7

8

6

2

1

3

4

8

7

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 100 086 (INTERNATIONAL STANDARD ELECT.) * Figuren 7-9; Seite 9, Zeilen 9-37; Seite 10, Zeilen 1-37; Seite. 11, Zeilen 1-9; Anspruch 9 * | 1,5 | G 02 B 6/42 H 01 L 31/0232 H 01 S 3/025 |
| A | | 4,6,8, 10 | |
| Y | US-A-4 474 306 (K. NAKAUCHI et al.) * Figur 3; Spalte 2, Zeilen 20-68; Spalte 3, Zeilen 1-11 * | 1,5 | |
| A | DE-A-3 630 795 (ANT NACHRICHTENTECHNIK) * Insgesamt * | 1,5,6, 10 | |
| A | DE-A-3 300 902 (HEWLETT-PACKARD) * Figur 1; Seite 5, Zeilen 25-29; Seite 6, Zeilen 1-32; Seite 7, Zeilen 1-6 * | 1,5,8, 10 | |
| A | PATENT ABSTRACTS OF JAPAN, Band 5, Nr. 19 (E-44)[691], 4. Februar 1981; & JP-A-55 146 986 (MITSUBISHI DENKI K.K.) 15-11-1980 * Insgesamt * | 1,5,7, 10 | RECHERCHIERTE SACHGEBIETE (Int. Cl.5) G 02 B 6/00 H 01 S 3/00 |
| A | US-A-4 776 659 (W.S. MURK) * Spalte 1, Zeilen 33-37 * | 9 | H 01 L 31/00 H 01 L 33/00 |

Der vorliegende Recherchenbericht wurde für alle Patentansprüche erstellt

| Recherchenort | Abschlußdatum der Recherche | Prüfer |
|---|---|---|
| DEN HAAG | 02-07-1990 | MATHYSSEK K. |

EPO FORM 1503 03.82 (P0403)